# EUROPEAN PATENT APPLICATION

(11) **EP 1 149 661 A2**
(43) Date of publication of application: **31.10.2001**
(21) Application number: 01302940.0
(22) Date of filing: 29.03.2001
(51) Int. Cl.: B23K 35/363, H05K 3/34

(54) **Soldering flux for circuit board and circuit board**

(30) Priority: 27.04.2000 JP 2000126793
(71) Applicant: Tamura Kaken Corporation, Irumi-shi, Saitama 358-8501 (JP)
(72) Inventor: Akaike, Shinichi, Iruma-shi, Saitama 358-8501 (JP); Ohno, Takao, Iruma-shi, Saitama 358-8501 (JP); Saito, Shoichi, Iruma-shi, Saitama 358-8501 (JP)
(74) Representative: Lawrence, John

(57) **Abstract**

There is provided a soldering flux for circuit board, which is designed to be employed on an occasion of soldering electronic parts on a circuit board, the soldering flux being free from any organic solvent which may become a cause for contaminating air atmosphere and being capable of providing an excellent insulating property. This soldering flux comprises; a rosin-based modified resin having an acid value of not less than 100, a nondissociative activator formed of a nondissociative halogenide, and an aqueous solvent containing a volatile basic agent. There is also provided a circuit board having a flux film formed from such a soldering flux.

## Description

### BACKGROUND OF THE INVENTION

The present invention relates to a flux of aqueous solvent type which is useful for soldering electronic parts on a circuit board, and also to a circuit board having a flux film formed thereon.

A circuit board for example a printed circuit board is generally formed of a copper-clad laminate on which a circuit wiring pattern is formed. This printed circuit board is adapted for mounting electronic parts thereon, thereby forming a circuit unit. On the occasion of mounting electronic parts such as a capacitor or a resistor, these electronic parts are solder to the copper foil lands, i.e. soldering lands of the circuit wiring pattern, thereby electrically connecting these electronic parts with the circuit wiring pattern.

There are known several methods for soldering electronic parts onto the printed circuit board, including for instance, a so-called jet type soldering method wherein a chip-like electronic part having electrodes on opposite ends for instance is temporarily secured to a predetermined location of the printed circuit board with these oppositely disposed electrodes being precisely positioned respectively at the soldering lands, and then, the temporarily secured electronic part is contacted with a fused solder which has been spouted out onto the printed circuit board; and a so-called reflow soldering method wherein a soldering paste is coated on the soldering lands, and after the electrodes of electronic part is positioned in the same manner as described above, the powdery solder of the soldering paste is heated and melted to solder the electronic part.

In either case of these known soldering methods, a flux is coated in advance on the printed circuit board before the electronic part is contacted with a fused solder or before the soldering paste is coated on the soldering lands, thereby preventing the generation of unsatisfactory soldering of the electronic parts due to the oxidation of the copper foil of the soldering lands that may be caused by the heating during the aforementioned soldering. Namely, even if the soldering lands of the printed circuit board are heated to a temperature in the range of 200 to 300°C during the aforementioned soldering, it is possible, due to the presence of the coating of flux during the soldering on the soldering lands irrespective of whether or not the surface of the soldering lands is covered in advance with a protective film, to shut out the penetration of oxygen through the coated film of flux to thereby prevent the oxidation of the copper foil. The coating of flux on the soldering lands is also effective in reducing any oxides that may happened to be already formed on the soldering lands, thereby providing an excellent wettability to a fused solder.

As for the materials for this flux, a rosin-based flux is predominantly employed. This rosin-based flux comprises a rosin-based resin as a main component, and an activator such as amine halogen salt or an organic acid, which are dissolved in an alcoholic solvent. As for the alcoholic solvent to be employed in this case, a solvent comprising isopropyl alcohol as a main component is generally employed because of the facts that the solvent is excellent in solubility to rosin-based resins as well as to various kinds of activators, that the allowable concentration for causing the explosion thereof in air is relatively high as compared with other kinds of organic solvent in spite of the relatively low boiling point thereof to thereby make it possible to minimize the risk of fire by the evaporation of solvent on the occasion of manufacturing or coating the flux, and that the solvent can be manufactured at a relatively low cost.

However, the employment of such a flux as mentioned above invites a problem that isopropyl alcohol is allowed to be discharged into air atmosphere on the occasion of coating the flux, thus inducing a cause for the contamination of environment such as the generation of photochemical smog. Therefore, it is now desired to take measure to minimize the discharge of isopropyl alcohol.

As a countermeasure for this problem, a water-soluble flux containing no volatile organic solvent has been developed. However, since a water-soluble substance such as glycol ether is included in this water-soluble flux, the employment of this water-soluble flux is accompanied with a problem that if the coating of this flux is left remained after finishing the soldering step, the short circuit of circuit pattern may be caused to occur due to the fact that the film of this flux is poor in insulating property. With a view to overcome this problem, it is practiced to ultimately remove the film of this flux by way of washing. However, the provision of this washing raises another problem that the productivity of the circuit unit would be deteriorated.

With a view to overcome this problem, there is also proposed a measure wherein a refined rosin containing abietic acid as a main component is turned into an ammonia salt or a salt of amine-based compound, thereby making the refined rosin soluble in water. However, since this measure necessitates the employment of a large quantity of ammonia or an amine-based compound in order to enable the refined rosin to become soluble in water, the coated film of this flux containing a large quantity of ammonia or an amine-based compound is poor in wettability to the fused solder, so that the solderability of the soldering lands would be deteriorated. For example, a so-called solder bridge where a solder is piled up bridging a pair of neighboring soldering lands or a defective soldering where a solder is not entirely adhered may be caused to generate on the printed circuit board. Additionally, since the film of flux which contains a large quantity of ammonia or an amine-based compound is poor in electric insulation, the short circuit of circuit pattern may be caused to occur, thereby giving rise to the malfunctioning of the circuit, thus deteriorating the reliability of the resultant device. Namely, it is difficult even with this measure to satisfy the properties which the non-washing type flux is demanded to have.

Further, according to the conventional flux, an activator consisting of an organic salt such as amine or an inorganic salt is included in the flux. However, since these salts are dissociative or ionic compounds, the film of flux containing these compounds tends to corrode a metallic portion of the circuit or deteriorate the electrical insulating properties of the flux, so that an improvement of reliability in this respect for the purpose of avoiding the malfunctioning of circuit is also desired. Especially in the case of a circuit board having a higher wiring density according to the recent technology, the requirements which the non-washing type flux is demanded to meet becomes increasing severe, so that the film of flux is now demanded to be further improved in electrical insulating properties thereof.

### BRIEF SUMMARY OF THE INVENTION

Therefore, a first object of this invention is to provide a soldering flux for circuit board, which is capable of minimizing or substantially preventing the discharge of organic solvent into air atmosphere.

A second object of this invention is to provide a soldering flux for circuit board, wherein the film thereof is not required to be washed.

A third object of this invention is to provide a soldering flux for circuit board, which does not badly affect the solderability of soldering lands, is hardly capable of corroding the soldering lands, and is excellent in electrical insulating properties and hence excellent in reliability.

A fourth object of this invention is to provide a soldering flux for circuit board, which is capable of improving the soldering productivity of the circuit board.

A fifth object of this invention is to provide a circuit board wherein the soldering lands thereof are protected by a coating of a soldering flux for circuit board, which is capable of achieving the aforementioned objects, thereby making it ready for mounting electronic parts.

A sixth object of this invention is to provide a circuit board having electronic parts mounted thereon, which is capable of ensuring the reliability with respect to the function of the circuit thereof, and also capable of ensuring an excellent productivity thereof, and which can be manufactured at a low cost.

The present invention has been made with a view to solve the aforementioned problems, and therefore, provides (1) a soldering flux for circuit board, which is designed to be employed on an occasion of soldering electronic parts on a circuit board, said soldering flux comprising; 0.1 to 30% by weight (based on the flux) of a rosin-based modified resin having an acid value of not less than 100, a nondissociative activator formed of a nondissociative halogenide, and an aqueous solvent containing a volatile basic agent.

The present invention also provides (2) a soldering flux for circuit board according to the aforementioned item (1), wherein said volatile basic agent is at least one kind of compound selected from the group consisting of ammonia, an amine compound represented by the following general formula (1), hydrazine, polyamine, nitrogen atom-containing heterocyclic compounds, alicyclic amine and aromatic amine. 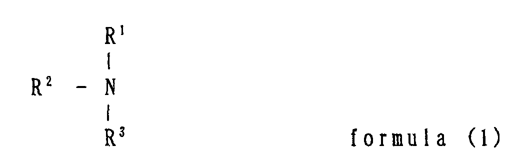 wherein R¹, R² and R³ may be the same or different and are individually hydrogen atom, alkyl group or alkanol group.

This invention further provides (3) a soldering flux for circuit board according to the aforementioned item (2), wherein said volatile basic agent has a boiling point of less than 200°C, and included in the flux at a ratio of 0.1 to 20% by mass based on the flux.

This invention further provides (4) a soldering flux for circuit board according to any one of the aforementioned item
(1) to (3), wherein said aqueous solvent is consisted of water and a water-soluble solvent, and the content of said water is more than 50% by mass based on the flux.
   This invention further provides (5) a soldering flux for circuit board according to any one of the aforementioned item
(2) to (4), wherein said aqueous solvent is consisted solely of water.

This invention further provides (6) a circuit board wherein the soldering lands thereof are protected by a coating of a soldering flux for circuit board according to any one of the aforementioned item (1) to (5), thereby making it ready for mounting electronic parts.

This invention further provides (7) a circuit board wherein electronic parts are soldered onto the soldering lands of the circuit board by making use of a soldering flux for circuit board according to any one of the aforementioned item (1) to (5).

### DETAILED DESCRIPTION OF THE INVENTION

In the description of this invention, the expression of "a rosin-based modified resin having an acid value of not less than 100" is intended to include an unsaturated organic acid-modified resin of rosin-based resin which can be produced according to Diels-Alder reaction, i.e. a resin which can be obtained through Diels-Alder reaction between a rosin-based resin and an unsaturated organic acid. This Diels-Alder reaction is also called a diene synthesis, wherein a compound having a double or triple bond is subjected to a 1,4-addition reaction with a compound having a conjugated double bond to thereby form a six-membered hydroaromatic ring. Namely, this reaction product is produced by making use of an unsaturated acid as the former reactant and rosin as the latter reactant.

As for the aforementioned rosin-based modified resin, it is possible to employ a substance containing, as a main component, abietic acid or a modified substance thereof such as an unsaturated organic acid-modified rosin-based resin or modified substances thereof wherein the rosin-based resin may be selected from those which can be employed as a reaction component of the Diels-Alder reaction, such as gum rosin, wood rosin, tall oil rosin, disproportionated rosin, polymerized rosin, hydrogenated rosin, etc. These resins or modified resins can be employed singly or in combination of two or more kinds. It is also possible to incorporate at least one kind of these rosin-based resin into the modified resin.

As for the unsaturated organic acid, it is possible to employ an aliphatic unsaturated monobasic acid such as acrylic acid, methacrylic acid, levulinic acid, et.; an aliphatic unsaturated dibasic acid such as α,β-unsaturated carboxylic acids such as fumaric acid, maleic acid, maleic anhydride, itaconic acid, itaconic anhydride, citraconic acid, citraconic anhydride, etc.; an aromatic ring-containing unsaturated carboxylic acid such as cinnamic acid. It is also possible to employ other kinds of unsaturated organic acid. These organic acids can be employed singly or in combination of two or more kinds.

It is possible, through the modification of a rosin-based resin with an unsaturated organic acid by means of the Diels-Alder reaction, to increase the acid value thereof higher than that of the raw rosin-based resin. The acid value however should preferably be 100 or more, most preferably 180 or more. If this acid value is too small, it would become difficult to dissolve the modified resin in water by making use of a basic agent.

It is required for these modified resins to have properties suited for use as a resin component of the film of flux so as not to badly affect the solerability of solder irrespective of the method of soldering, i.e. either the wave type soldering method or the reflow soldering method, so that these modified resins should have a suitable softening point (as measured by way of the ring and ball method as defined by JIS), i.e. in the range of 60-150°C in the case of the wave type soldering method, and in the range of 70-150°C in the case of the reflow soldering method, which is a little higher than that of the wave type soldering method because the soldering temperature is a little higher than that of the wave type soldering method. If the softening point is too low, the film of flux would become too tacky, while if the softening point is too high, the characteristic of the film of flux that it can be easily moved away by the fused solder would be damaged, thus deteriorating the wettability of the fused solder to the soldering lands.

The Diels-Alder reaction between a rosin-based resin and an unsaturated organic acid can be executed for example by a method which is known as so-called manufacturing method of enforced rosin wherein the unsaturated organic acid is gradually added to the rosin-based resin which is being maintained in a molten state.

The aforementioned unsaturated organic acid-modified resin of rosin-based resin can be included in a flux at a ratio of 0.1 to 30%. If the content of this modified resin is too little, the flux is no longer capable of functioning the characteristics expected thereof. On the other hand, if the content of this modified resin is too large, it will lead not only to an increase of the manufacturing cost thereof but also to an increase in viscosity of flux, thereby making it difficult to uniformly coat it on the surface of printed circuit board. Additionally, the thickness of the film of flux becomes too large, thereby deteriorating the wettability of the fused solder to the soldering lands.

In this invention, an aqueous solvent is employed as a constituent component of the flux. The expression of aqueous solvent means in this invention that the solvent is constituted solely be water or constituted by a mixed solvent consisting of water and an organic solvent which is capable of being dissolved into water.

In the case where only water is employed as the solvent, a rosin-based modified resin having an acid value of not less than 100 such as an unsaturated organic acid-modified resin of rosin-based resin obtained by way of the Diels-Alder reaction should preferably be employed together with a basic agent so as to enable the modified resin to be dissolved in water as a salt. In this case, if the resin employed has a large acid value, the resin can be dissolved in water while making it possible to reduce the quantity of the basic agent to be added.

The employment only of water as a solvent for the flux is preferable in the respect that no organic solvent is released into air atmosphere on the occasion of coating the flux. On the other hand, a solvent where an organic solvent is co-used together with water, the risk of reaching an explosion limit concentration of the organic solvent in air atmosphere can be extremely minimized as compared with the conventional organic solvent type flux. Further, even if the organic solvent is allowed to be released into air atmosphere, the concentration of the released organic solvent would be confined to an extremely lower level as compared with the concentration which would bring about a photochemical smog, thereby making it possible to improve at least the existing state of the conventional organic solvent type flux. For the purpose of this improvement, the content of water in the flux should preferably be 50% or more. For example, if the flux is assumed to contain 0.1 to 30% of the aforementioned modified resin, 0.1 to 20% of a basic agent, and not less than 50% of water, the content of an organic solvent would be fairly limited since other components such as an activator would be further included in the flux.

When an organic solvent is co-used together with water as a solvent, the solubility of the aforementioned modified resin can be enhanced even if the content of the organic solvent is not more than several % based on the flux, thereby making it possible to lower the viscosity of the flux. As a result, the coating property of the flux is most likely to be improved, and even if the content of a basic agent for promoting the solubility in water of the modified resin is reduced, the solubility of the modified resin would not be substantially deteriorated. Additionally, if the content of the organic solvent is minimized in this manner, the problems accompanied with the release of an organic solvent on the occasion of coating or manufacturing the flux can be also eliminated remarkably.

As for the organic solvent which is capable of being dissolved into water, since there is a case where an organic solvent is included in the flux at a content of several %, any organic solvent which is capable of exhibiting a sufficient solubility in water at such a concentration can be employed. More specifically, alcoholic solvents can be generally employed, isopropyl alcohol being more preferable among the alcoholic solvents. These organic solvents can be employed singly or in combination of two or more kinds.

If a rosin-based modified resin having an acid value of not less than 100 such as an unsaturated organic acid-modified resin of rosin-based resin to be obtained by way of the Diels-Alder reaction is to be dissolved in a solvent consisted only of water, it would be preferable to co-use a basic agent so as to enable the modified resin to be dissolved in water as a salt. As for the basic agent useful in this case, a basic compound which can be eliminated from the film of flux upon finishing the soldering after the coating of flux is preferable in view of ensuring the electrical insulating property of the flux. For example, so-called volatile basic agents having a boiling point of not more than 200°C are preferable.

Specific examples of this basic agent include ammonia, an amine compound represented by the following general formula (1), hydrazine, polyamine, nitrogen atom-containing heterocyclic compounds, alicyclic amine and aromatic amine. These basic agents can be employed singly or in combination of two or more kinds.

More specifically, aliphatic amines such as a lower alkyl amine such as ethyl amine (boiling point: 38°C) and triethyl amine (boiling point: 89.7°C) as well as alkanol amines such as monoethanol 1 amine can be employed as the aforementioned amine compound. As for the polyamine, it is possible to employ ethylene diamine, diaminopropane, etc. As for the nitrogen atom-containing heterocyclic compounds, it is possible to employ pyridine. As for the alicyclic amine, it is possible to employ piperizine, pipecorrin, etc. As for the aromatic amine, it is possible to employ benzyl amine, etc.

The aforementioned basic agent should preferably be included in a flux at a ratio of 0.1 to 20% by mass. If the content of this basic agent is too little, the effect of the basic agent to solubilize the resin in water would become insufficient. On the other hand, if the content of this basic agent is too large, it will lead not only to the deterioration in electrical insulating property of the flux but also to the corrosion of the soldering lands, thereby deteriorating not only the electric conductivity of the soldering land but also the bonding strength of the solder.

By the way, the pH of the flux according to this invention should preferably be not more than 10, more preferably in the range of 7 to 9. If this pH is more than 10, the solderability of solder would be badly affected.

The flux according to this invention contains "a nondissociative activator formed of a nondissociative halogenide". As for the nondissociative halogenide, it is possible to employ a non-salt type organic compound where a halogen atom is bonded to an organic compound through a covalent bond. If halogen atom is nondissociative, it becomes possible to inhibit the corrosion of metal portion of circuit board as well as to minimize the possibility of deteriorating the electrical insulation property of the flux even if the halogen atom is left remained in the flux. When this nondissociative halogenide is exposed to a high temperature of 200°C or more, or a melting point of a fused solder, during the soldering, part of the halogenide is decomposed to thereby generate a halogen atom or a simple compound, thereby enabling the halogenide to become active. If in this case the decomposed product is volatile, any ionic substances can be prevented from being left remained in the flux.

As for the halogenide, it may be a compound wherein chlorine atom, bromine atom or fluorine atom is singly included in a compound through a covalent bond such as a chloride, bromide or fluoride, or alternatively, it may be a compound wherein two or more kinds of atom selected from chlorine atom, bromine atom and fluorine atom are included in a compound through a covalent bond. It is preferable, in view of improving the solubility to an aqueous solvent, that the halogenide has a polar group such as hydroxyl group as in the case of alcohol halide. Examples of alcohol halide include alcohol bromides such as 2,3-dibromopropanoi, 2,3-dibromobutanediol, 1,4-dibromo-2-butanol or tribromoneopentylalcohol; alcohol chlorides such as 1,3-dichloro-2-propanol or 1,4-dichloro-2-butanol; alcohol fluorides such as 3-fluorocatechol; and the like.

The aforementioned nondissociative activator may be co-used together with other active agents such as amines, amine salts (organic acid salts of amines such as polyamine such as ethylene diamine, cyclohexyl amine and diethyl amine; and inorganic acid salt (such as a salt of mineral acid such as hydrochloric acid, sulfuric acid, etc.)); organic acids, amino acids; amide-based compounds, etc. The content of these active agents in the flux should preferably be within the range of 0.1 to 10% by mass. On the other hand, the content of the nondissociative activator should preferably be within the range of 0.1 to 10% by mass. If the content of the nondissociative activator is less than the aforementioned lower limit, a defective soldering such as bridging or icicle may be more likely to be caused to generate. On the other hand, if the content of the nondissociative activator is more than the aforementioned upper limit, the solubility thereof would be deteriorated, thereby possibly lowering the stability of the composition of the flux solution.

The flux according to this invention can be manufactured as follows. Namely, a rosin-based modified resin having an acid value of not less than 100 such as an unsaturated organic acid-modified resin of rosin-based resin to be produced according to Diels-Alder reaction is gradually added to a mixture consisting of water and the aforementioned basic agent, and dissolved therein with stirring to obtain a resin mixture. Thereafter, an activator and other auxiliary agents such as other kinds of resin or a plasticizer are optionally added to the aforementioned resin mixture, thus obtaining a flux.

Alternatively, the aforementioned modified resin may be dissolved in advance in an organic solvent to obtain a solution, which is then added to a mixture consisting of water and the aforementioned basic agent to obtain a resin mixture, to which other auxiliary agents are optionally added, thus obtaining a flux. If an organic solvent is desired to be included in the flux in this case, the organic solvent may be employed for dissolving the aforementioned modified resin to obtain a resin solution to which an additional quantity of the organic solvent, for make up the shortage thereof if any, may be added. Thereafter, the same procedures as described above will be followed to obtain a flux. When the aforementioned modified resin is dissolved in advance in an organic solvent in this manner, the workability of dissolving this modified resin in a mixture consisting of water and the basic agent can be improved. On the other hand, if an organic solvent is not desired to be included substantially in the flux, the organic solvent may be allowed to evaporate on the occasion of stirring the resin mixture containing the modified resin and a mixture consisting of water and the basic agent for dissolving the modified resin in the latter mixture. The organic solvent to be employed in this case should preferably be selected from those which are volatile.

As for the method of coating the flux of this invention onto a printed circuit board, it is possible to employ any conventional coating method of flux, such as a roll coating method, a dip coating method, a spray coating method, or a bubble coating method wherein the flux is bubbled in advance by blowing air for example into the flux, and the resultant foam produced is allowed to adhere onto the surface of printed circuit board.

The film of flux (flux film) according to this invention which has been coated and dried in this manner is substantially consisted of the aforementioned modified resin and active agents including the aforementioned nondissociative halogenide without containing the aforementioned water and basic agent which have been eliminated through evaporation. Since this modified resin fundamentally exhibits the properties of rosin-based resin, the flux film is capable of shutting oxygen of air atmosphere away from the soldering lands and preventing the copper surface thereof from being oxidized until the fused solder is allowed to contact with the flux in either the jet soldering method or the reflow soldering method. However, once the fused solder is allowed to contact with the flux, the flux is caused to melt due to the heat of solder so as to be pushed away by the solder from the soldering lands where the flux has been coated in advance, thereby allowing the soldering lands to be exposed. On this occasion, the active agent (activator) functions to reduce copper oxides that may happen to be formed on the soldering lands prior to the coating of flux or on the occasion of performing the soldering thereof, thereby enabling the fused solder to be sufficiently wettable to the soldering lands made of copper metal.

Since the basic agent is already eliminated from the modified resin after the step of soldering if a volatile basic agent is employed as the basic agent, the modified resin would not be dissolved in water. Namely, since the hydrophilic resin is turned into a hydrophobic resin after the step of soldering, the electrical insulation property of the surface of circuit board after the mounting of electronic parts would not be badly affected by the coating of the flux, and hence, the generation of short circuit of circuit pattern can be prevented, thereby improving the reliability of the circuit board.

The flux of this invention is adapted to be coated on a printed circuit board and is not required to be washed away even after the soldering step. Namely, the flux of this invention may be left coated on the surface of circuit board even after the mounting of electronic parts. Therefore, this invention provides a circuit board having electronic parts mounted thereon with the flux film being left remained on the circuit board.

The flux of this invention can be coated on the surface of a printed circuit board upon finishing the formation of the pattern of circuit wiring thereon through an etching treatment of a copper-clad laminate, or upon finishing a soft etching treatment to remove copper oxides formed on the surface of the circuit pattern, thereby enabling the flux to function as a protecting film for protecting the circuit pattern from being oxidized until the step of soldering. Therefore, this invention provides a printed circuit board having a protecting film formed thereon.

Further, it is possible, according to this invention, to provide a circuit board with or without electronic parts being mounted thereon, the circuit board having a coated film of flux comprising a rosin-based modified resin having an acid value of not less than 100 or an unsaturated organic acid-modified rosin-based resin obtained through the Diels-Alder reaction, wherein the modified resin is made water-soluble before coating by making use of a volatile basic agent which is subsequently removed from the film of flux.

As explained hereinafter in details, the rosin-based modified resin having an acid value of not less than 100 can be obtained by increasing the acid value thereof through the Diels-Alder reaction between a rosin-based resin and an unsaturated organic acid for example. More specifically, such a rosin-based modified resin may be a Diels-Alder reaction product between rosin and acrylic acid, maleic acid or levulinic acid. The larger the acid value is, the larger the proportion in the molecule which forms a salt thereof with a basic agent, thereby enhancing the solubility thereof in water due to the hydrophilization thereof by the salt, thus enabling the modified resin to be dissolved in a solvent consisting only of water.

The principle of this phenomenon can be illustrated by the following reaction formula. In this formula, R-COOH constituting the component (a) represents an acid group of abietic acid or of a modified compound thereof, the component (b) represents the basic agent, and the component (c) represents a reaction product or a salt which makes the modified resin soluble in water. 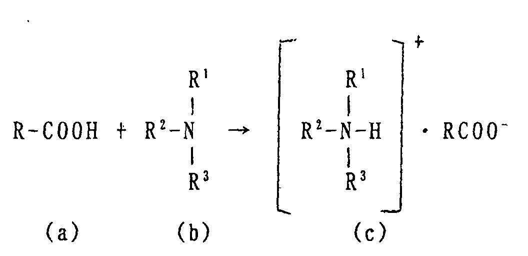 wherein R¹, R² and R³ may be the same or different and are individually hydrogen atom, alkyl group or alkanol group.

If a volatile basic agent is employed as the aforementioned basic agent on this occasion, this volatile basic agent can be evaporated simultaneous with the removal of water, thereby turning the moiety of the salt into a relatively hydrophobic moiety. As a result, the modified resin can no longer be dissolved in a solvent consisting only of water. Since the hydrophobic film would not give a bad influence to the electrical insulation property of the circuit board, the hydrophobic film is no longer required to be removed by way of washing for instance.

Since alcohol halide, in particular alcohol bromide, to be employed as a nondissociative activator is nonionic, a flux film containing alcohol halide would not give rise to the corrosion of the circuit of circuit board or to the deterioration of the flux film functioning as an insulating film. Moreover, since this flux film can be decomposed as it is heated up to a high temperature of 200°C or more which is a melting point of a fused solder to be employed on the occasion of soldering, the activity of the decomposed products can be utilized. Furthermore, if the decomposed products produced in this case are volatile, they can be prevented from being left remained in the flux film.

### (Example)

Next, the examples of this invention will be explained as follows.

The flux of this invention can be employed in the same manner as the conventional flux, thereby enabling the flux film to be formed on the surface of printed circuit board. In the following examples, the flux as well as the circuit board having this flux film formed thereon will be explained.

First of all, an unsaturated organic acid-modified rosin-based resin to be obtained through the Diels-Alder reaction was manufactured as follows.
(A) The manufacture of an acrylic acid-modified resin of rosin:
   1 mole of rosin having an acid value of 170 and a softening temperature of 70°C (as measured by way of the ring and ball method as defined by JIS; the same hereinafter) was allowed to react with 0.8 mole of acrylic acid while dropping and refluxing the acrylic acid under an air atmosphere at a temperature of 250°C for 8 hours.
   The acrylic acid-modified resin of rosin thus obtained was 260 in acid value and 130°C in softening point.
(B) The manufacture of a maleic acid-modified resin of rosin:
   4 moles of rosin having an acid value of 170 and a softening temperature of 70°C was allowed to react with 1 mole of maleic acid by heating them at a temperature of 200°C for 8 hours.
   The maleic acid-modified resin of rosin thus obtained was 289 in acid value and 135°C in softening point.
(C) The manufacture of a levulinic acid-modified resin of rosin:

4 moles of rosin having an acid value of 170 and a softening temperature of 70°C was allowed to react with 2 moles of levulinic acid by heating them at a temperature of 200°C for 8 hours.

The levulinic acid-modified resin of rosin thus obtained was 270 in acid value and 129°C in softening point.

All of these modified resins exhibited respectively an increased acid value which was higher by a value of 90 to 118 (52.9 to 70%) as compared with that of the rosin employed as a raw material. In view of the fact that the acid value of these modified resins was 180 or more, the expression of "rosin-based modified resin having an acid value of not less than 100" may be expressed by an alternative expression of: "an unsaturated organic acid-modified rosin-based resin obtained through the Diels-Alder reaction", by an expression of: "an unsaturated organic acid-modified rosin-based resin obtained through the Diels-Alder reaction and having an acid value ranging from 180 to 300", or by an expression of: "an unsaturated organic acid-modified rosin-based resin obtained through the Diels-Alder reaction and having an acid value which is higher by 5.8% (when the acid value of the modified rosin-based resin is assumed as being 180) or more, or higher by 50% or more, more specifically higher by 50 to 75% as compared with that of raw rosin-based resin".

This invention will be further explained with reference to the following examples which are not intended to limit this invention. The "%" in these examples is expressed on the basis of weight.

### Example 1

925g of water was placed in a 2000mL vessel, into which raw materials were added according to the composition shown below. Namely, aqueous ammonia (28% aqueous solution of ammonia) was added to the water with stirring. Then, under stirring, the acrylic acid-modified resin of rosin obtained as described above (A) was gradually added to the above ammonia solution. After the resultant mixture was kept stirred for 60 minutes, 2,3-dibromopropanol was added to the mixture and homogenized with stirring, thereby obtaining a flux.

| | |
|---|---|
| Acrylic acid-modified resin of rosin (A) (solid matter) | 5% |
| Aqueous ammonia (28% aqueous solution) | 2% |
| 2,3-dibromopropanol | 0.5% |
| Water | 92.5% |
| Total | 100% |

The pH of the flux thus obtained was found 9. Further, the following tests were also performed on this flux.

### (a) Solubility test

The flux thus manufactured was placed into a glass tube, and the solubility thereof was visually inspected, the results being shown in the following Table 2.

In Table 2, the mark 0 represents a phenomenon where the flux was transparent, indicating an excellent solubility; the mark Δ represents a phenomenon where the flux was somewhat turbid; the mark X represents a phenomenon where the flux was poorly dissolved; and the mark - represents a phenomenon where the flux was not dissolved at all so that no test could be per formed.

### (b) Solder spreadability test

A copper plate (30mm × 30mm × 0.2mm) was subjected to a soft etching treatment by dipping the copper plate in an aqueous solution containing 11% of sulfuric acid, and 3.8% of hydrogen peroxide for 60 seconds at a temperature of 20±1°C. Then, the copper plate was taken out of the aqueous solution and washed with deionized water for 30 seconds. Thereafter, the copper plate was washed with isopropyl alcohol and then with ethyl acetate. The copper plate thus washed was sufficiently dewatered and then air-dried.

Then, the flux described above was coated on this copper plate and allowed to dry to form a flux film thereon. The resultant copper plate bearing this flux film was subjected to the solder spreadability test according to JIS-Z-3197 (1986).

### (c) Copper plate corrosion test

The copper plate bearing this flux coating thereon was subjected to the test according to JIS-Z-3197 (1986).

### (d) Insulation resistance test

A tandem type substrate bearing this flux coating thereon was subjected to the test according to JIS-Z-3197 (1986).

### (e) Test of moisture vapor resistance with the application of voltage

A tandem type substrate bearing this flux coating thereon was subjected to the test according to JIS-Z-3197 (1986).

### Examples 2 and 3

Samples of flux were manufactured in the same manner as described in Example 1 except that the compositions shown in each column of Table 1 were employed for Examples 2 and 3. The results of the tests which were performed in the same manner as in Example 1 are shown in Table 2.

### Example 13 (An example of a circuit board before electronic parts were mounted thereon)

In view of the protective performance of the copper surface, the copper plate covered with a flux film employed in the aforementioned test (b) can be assumed as being a printed circuit board having a protective film formed at the soldering lands thereof prior to the mounting of electronic parts. Therefore, the example of the copper plate covered with a flux film can be assumed as being an example of circuit board of this invention prior to the mounting of electronic parts.

### Example 14 (An example of a circuit board after electronic parts were mounted thereon)

In view of the electrical insulation of the copper in the aforementioned test (c) as well as in view of the moisture resistance thereof in the aforementioned test (d), the copper plate covered with a flux film employed in the aforementioned test (b) can be assumed as being a printed circuit board having an insulation film formed at the soldering lands thereof and also having electronic parts mounted thereon. Therefore, the example of this copper plate covered with a flux film can be assumed as being an example of circuit board of this invention wherein electronic parts have been mounted thereon.

Even when the maleic acid-modified resin of rosin and the levulinic acid-modified resin of rosin, which were manufactured in the aforementioned procedures (A) and (B), were substituted for the acrylic acid-modified resin of rosin in the above Examples 1 to 3, almost the same results as obtained in these Examples were obtained.

### Comparative Examples 1 to 3

Samples of flux were manufactured in the same manner as described in Example 1 except that the compositions shown in each column of Table 1 were employed for Comparative Examples 1 to 3. The results of the tests which were performed in the same manner as in Example 1 are shown in Table 2.

**Table 1**

| | Examples | | | Comp. Examples | | |
|---|---|---|---|---|---|---|
| | 1 | 2 | 3 | 1 | 2 | 3 |
| (Modified resins) | | | | | | |
| Rosin-Acrylic acid-modified | 5 | 5 | 5 | 5 | | 5 |
| Hydrogenated rosin | | | | | 5 | |
| (Activators) | | | | | | |
| 2,3-dibromopropanol | 0.5 | 0.5 | 0.5 | | | |
| Adipic acid | | | | 0.1 | 0.1 | |
| Amide acetate | | 0.1 | 0.1 | | | |
| Diethyl amine hydrochloride | | | | | | 0.1 |
| (Basic agents) | | | | | | |
| Ammonia | 2 | 2 | | | | |
| Ethyl amine | | | 2 | | | |
| (Solvents) | | | | | | |
| Water | 92.5 | 92.4 | 92.4 | 94.9 | | |
| Isopropyl alcohol | | | | | 94.9 | 94.9 |
| Total (parts by weight) | 100 | 100 | 100 | 100 | 100 | 100 |

**Table 2**

| Test items | Examples | | | Comp Examples | | |
|---|---|---|---|---|---|---|
| | 1 | 2 | 3 | 1 | 2 | 3 |
| Solubility | ○ | ○ | ○ | × | ○ | ○ |
| Solder spread (%) | 91 | 91 | 91 | - | 91 | 91 |
| Corrosion of Cu plate | OK | OK | OK | - | OK | OK |
| Surface Insulation resistance (Ω) | 9×10¹³ | 9×10¹³ | 8×10¹³ | - | 4×10¹³ | 4×10¹³ |
| Surface Insulation resistance after appl. of voltage (Ω) | 1×10¹³ | 1×10¹³ | 1×10¹³ | - | 2×10¹² | 1×10¹² |
| Corrosion after the appl. of voltage | OK | OK | OK | - | OK | OK |
| pH | 9 | 9 | 9 | - | - | - |

It will be seen from these results that the flux films according to this invention were incapable of corroding the copper plate and had a surface insulation resistance of 10¹³ Ω or more. Furthermore, the surface insulation resistance after the application of voltage was also 10¹³ Ω or more, and it was also possible to prevent the copper plate from being corroded after the application of voltage. Therefore, the term of "flux" can be also defined as being "one or more kinds of flux whose films are incapable of corroding the copper plate and had a surface insulation resistance of 10¹³ Ω or more, and also are incapable of corroding the copper plate after the application of voltage and had a surface insulation resistance of 10¹³ Ω or more even after the application of voltage.

It is possible, according to this invention, to provide a flux comprising a rosin-based modified resin having an acid value of not less than 100, a nondissociative activator and an aqueous solvent, so that the quantity of organic solvent to be used can be minimized. In particular, when a basic agent is co-used in this flux, the flux can be easily made completely aqueous. As a result, the release of organic solvent into air atmosphere during the manufacture of flux or during the coating of flux can be greatly minimized or completely prohibited, which is advantageous in terms of environmental sanitation for an operator as well as in terms of minimizing the risk of generating fire or photochemical smog, i.e. which is also advantageous in terms of inhibiting environmental contamination.

Further, since the rosin-based modified resin having an acid value of not less than 100 is capable of increasing the acid value thereof as compared with that of the rosin-based resin, the quantity of the basic agent, if co-used for the purpose of water-solubilizing the flux, can be reduced, thereby making it possible to avoid the deterioration in wettability of the fused solder on the occasion of soldering. On the other hand, the nondissociative activator is capable of being partially decomposed as it is exposed to a high temperature of the fused solder during the soldering, thereby generating halogen atoms or the compounds thereof, enabling them to function as an active agent without badly affecting the solderability of solder. It is more preferable that these active agents are volatile.

When the basic agent employed is volatile, the basic agent can be removed through the evaporation thereof after the formation of the flux film, thereby making the flux film hardly soluble in water. Moreover, even if the flux contains a nondissociative activator and this nondissociative activator is left remained in the flux even after the mounting of electronic parts, since this activator is nonionic, the electrical insulation property of the flux can be retained without corroding the soldering lands made of copper foil, thereby making it possible to enhance the reliability of the resultant product.

Further, since the electrical insulation property of the flux film can be retained without corroding the soldering lands, the flux film is no longer required to be removed by way of washing, thereby making it possible to omit the washing step. Namely, it is possible to enhance the productivity of the flux as compared with that of the conventional wash-type flux.

The film of flux according to this invention which is excellent in solderability and incapable of corroding the soldering lands is also effective as a protective film for the soldering lands of printed circuit board prior to the mounting of electronic parts. Therefore, it is possible according to this invention to provide a printed circuit board wherein the soldering lands thereof are protected with a protective film prior to the mounting of electronic parts, thus functioning in the same manner as that of the conventional counterpart,

Further, since the film of flux according to this invention is excellent in electrical insulation property without corroding the soldering lands, it can be utilized as an insulating film for the circuit board having electronic parts mounted thereon, thereby making it possible to provide a circuit board having electronic parts mounted thereon and functioning in the same manner as that of the conventional counterpart.

It is possible according to this invention to manufacture a circuit board with or without electronic parts mounted thereon by a method which would not release any organic solvent into air atmosphere, thereby achieving an epoch-making effect in terms of environmental pollution control.

## Claims

1. A soldering flux for circuit board, which is designed to be employed on an occasion of soldering electronic parts on a circuit board, said soldering flux comprising; 0.1 to 30% by mass (based on the flux) of a rosin-based modified resin having an acid value of not less than 100, a nondissociative activator formed of a nondissociative halogenide, and an aqueous solvent containing a volatile basic agent.

2. The soldering flux for circuit board according to claim 1, wherein said nondissociative halogenide is alcohol halide.

3. The soldering flux for circuit board according to claim 2, wherein said alcohol halide is added to said flux at a ratio of 0.1 to 10% by mass (based on the flux).

4. The soldering flux for circuit board according to any one of claims 1 to 3, wherein said volatile basic agent is at least one kind of compound selected from the group consisting of ammonia, an amine compound represented by the following general formula (1), hydrazine, polyamine, nitrogen atom-containing heterocyclic compounds, alicyclic amine and aromatic amine. 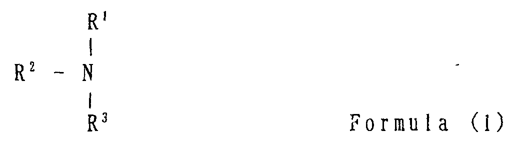 wherein R¹, R² and R³ may be the same or different and are individually hydrogen atom, alkyl group or alkanol group.

5. The soldering flux for circuit board according to claim 4, wherein said volatile basic agent has a boiling point of less than 200°C, and included in the flux at a ratio of 0.1 to 20% by mass based on the flux.

6. The soldering flux for circuit board according to any one of claims 1 to 5, wherein said aqueous solvent is consisted of water and a water-soluble solvent, and the content of said water is less than 50% by mass based on the flux.

7. The soldering flux for circuit board according to any one of claims 4 to 6, wherein said aqueous solvent is consisted solely of water.

8. A circuit board wherein the soldering lands thereof are protected by a coating of the soldering flux for circuit board according to any one of claims 1 to 7, thereby making it ready for mounting electronic parts.

9. A circuit board wherein electronic parts are soldered onto the soldering lands thereof by making use of the soldering flux for circuit board according to any one of claims 1 to 7.
